# EUROPEAN PATENT APPLICATION

(11) **EP 2 395 545 A1**
(43) Date of publication of application: **14.12.2011**
(21) Application number: 10758353.6
(22) Date of filing: 26.02.2010
(51) Int. Cl.: H01L 21/3065, H01L 21/205, C01B 7/20

(54) **SYSTEM FOR IN-SITU MIXING AND DILUTING FLUORINE GAS**

(30) Priority: 03.04.2009 JP 2009091285
(71) Applicant: Central Glass Company, Limited, Yamaguchi 755-0001 (JP)
(72) Inventor: KIKUCHI, Akiou, Ube-shi Yamaguchi 755-0001 (JP); MORI, Isamu, Ube-shi Yamaguchi 755-0001 (JP); YAO, Akifumi, Ube-shi Yamaguchi 755-0001 (JP); MIYAZAKI, Tatsuno, Ube-shi Yamaguchi 755-0001 (JP); NAKAHRA, Keita, Ube-shi Yamaguchi 755-0001 (JP)
(74) Representative: Manitz, Finsterwald & Partner GbR
(86) International application number: PCT/JP2010/053040
(87) International publication number: WO 2010/113576

(57) **Abstract**

**[Task]** It is a task to provide a fluorine gas supply system which can stably supply fluorine gas generated by a fluorine gas generation device to a semiconductor processing device in a large quantity and in a precise concentration.

**[Means for solving task]** In the fluorine gas supply system, a mixed gas stored in a buffer tank is introduced into a gas introducing piping before the mixed gas is adjusted in the buffer tank to circulate the mixed gas and a monitoring device is disposed which measures a fluorine gas concentration within the mixed gas so that, in response to the obtained fluorine gas concentration, a flow quantity of inert gas supply source can be adjusted.

## Description

### TECHNICAL FIELD

The present invention relates to a supply system for fluorine gas between an on-site fluorine gas generation device and a semiconductor processing device in which fluorine gas is used and relates to a system for in-situ mixing and diluting fluorine gas.

### BACKGROUND ART

A large quantity of electronic material gas (for example, fluoride gas such as fluorocarbon, sulfur hexafluoride, nitrogen tri-fluoride, or so forth) has, heretofore, been used over a wide range for cleaning and etching processes in semiconductor processing steps due to a high performance thereof. However, since these fluoride gases have large global warming potentials and give ill influences on global environments, it has already been decided that these fluoride gases will, in the future, be abolished or their uses will be limited.

Fluorine gas has zero global warming potential and its use as an alternative to fluoride gas has started to be discussed. Fluorine gas is remarkably strong in its toxicity, corrosiveness, and reactivity so that insecurity is involved when large quantity transportation and storage of fluorine gas filled up within gas cylinders are carried out. Therefore, such a method of supplying fluorine gas has been put into practice that fluorine gas diluted by inert gas such as nitrogen gas or helium gas up to about 20% or lower and filled up within the gas cylinder.

However, in the gas cylinder in which fluorine gas is diluted by inert gas, a filling quantity of fluorine gas becomes small. Hence, a replacement frequency of the gas cylinder becomes accordingly increased. Whenever the gas cylinder has been replaced, it is necessary to optimize the process of the fluorine gas supply and such a problem that an efficiency of productivity is reduced occurs.

In addition, if the gas cylinder is exposed under high pressure in order to maximize the filling quantity of fluorine gas within the gas cylinder, a potential insecurity will be raised such as a breakage of vessels for gas supply.

An industrial field desires an on-site fluorine gas generation device which generates fluorine gas in safety and stable manners and which is used on-site and several proposals thereof have been made (Patent documents 1 and 2).

However, little consideration has presently been given to an interface-like device (the supply system of fluorine gas) to secure the supply of fluorine gas between the on-site fluorine gas generation device and the semiconductor processing device in spite of the fact that the interface-like device is extremely important.

### Pre-published document

### Patent document

Patent document 1: JP (tokkai) 2004-169123
Patent document 2: JP (tokkai) 2007-191378

### DISCLOSURE OF THE INVENTION

### Task to be solved by the invention

Two methods have conventionally been carried out, one of the methods being such that fluorine gas obtained by on-site fluorine gas generation device is directly introduced into a buffer tank and the introduced fluorine gas is diluted at a portion of the gas supply system immediately before the introduction of fluorine gas into the semiconductor processing device and the other method being such that each component of obtained fluorine gas and inert gas is separately flow quantity controlled and is circulated, these gases are joined and are stored in the buffer tank, the flow quantity control of mixed gas of these gases is performed, and flow controlled mixed gas is introduced into the semiconductor processing device, when obtained fluorine gas is introduced into the semiconductor processing device in which fluorine gas is used.

It is not preferable to store a large quantity of fluorine gas into the buffer tank since fluorine gas is remarkably strong in toxicity and corrosiveness in the method in which obtained fluorine gas is directly introduced into the buffer tank. In addition, in recent years, a large sized silicon wafer has started to be used since substrates used in the semiconductor processing steps have become large sized in order to improve a production efficiency. In order to cope with the large sizing of the silicon wafer, the large sizing of the semiconductor processing device such as a CVD device, an etching device, and so forth has been carried out. Along with the large sizing of the semiconductor processing device, a usage quantity of fluorine gas used in cleaning and etching processes is abruptly increased.

Therefore, along with the increase in the usage quantity of fluorine gas, in the method in which fluorine gas obtained in the on-site fluorine gas generation device is introduced into the semiconductor processing device in which fluorine gas is used, a larger sized buffer tank has become in use to enable a large quantity supply of fluorine gas.

In a case where mixed gas is stored using a large sized buffer tank which is possible in a large quantity supply of fluorine gas, it becomes more difficult to uniformize mixed gas as a tank size becomes larger. It is merely possible to uniformize mixed gas by leaving mixed gas alone for a long time. However, in the conventional method, a time for each component of mixed gas to be uniformized becomes long so as to bring out a reduction in productivity.

Furthermore, along with miniaturization and high integration of integrated circuits, a required accuracy for the concentration of fluorine gas to be used becomes higher. Therefore, it is necessary to uniformize each component of mixed gas positively and, thereafter, it is necessary to adjust mixed gas to the concentration of fluorine gas to meet the required accuracy.

It is a task of the present invention, in view of the above-described problems, to provide a fluorine gas supply system which can stably supply fluorine gas generated in a fluorine gas generation device in a large quantity and in a precise concentration to a semiconductor processing device.

### Means for solving the task

The present inventors and so forth have discovered, as a result of their active considerations to solve the above-described task, that the mixed gas stored in the buffer tank is introduced into a gas introducing piping before an adjustment of the mixed gas within the buffer tank and the mixed gas is circulated, and a monitoring device to measure a fluorine concentration in the mixed gas is provided to adjust a flow quantity of a gas supply source constituted by fluorine or inert gas in response to the obtained fluorine concentration so that fluorine gas generated in the fluorine gas generation device can be supplied to the semiconductor processing device, in a stable manner, in a large quantity, and in a precise concentration and have reached to the present invention.

That is to say, according to one aspect of the present invention, there is provided with a system disposed within a gas supply system of a semiconductor processing device for supplying fluorine gas, comprising: a gas supply section including gas supply sources of fluorine gas and inert gas; a buffer tank storing a mixed gas of fluorine gas and inert gas; a piping A into which gas of each of the gas supply sources is introduced and for connecting each of the gas supply sources to the buffer tank; a piping B for connecting the buffer tank to the piping A and for circulating the mixed gas within the buffer tank to uniformize a concentration of fluorine within the mixed gas; a gas piping C for connecting the buffer tank to the semiconductor processing device; a gas flow quantity adjustment device disposed in the inert gas supply source of the gas supply section for adjusting a flow quantity of inert gas; another gas flow quantity adjustment device disposed in the gas piping C for adjusting the flow quantity of gas to be supplied from the buffer tank to the semiconductor processing device; and a monitoring device configured to measure the concentration of fluorine in the mixed gas and, in response to a measurement of the concentration of fluorine, to adjust the flow quantity adjustment device for adjusting the flow quantity of inert gas to maintain the concentration of fluorine at a predetermined concentration.

### Effect of the Invention

The fluorine gas supply system according to the present invention can supply fluorine gas in the stable manner, in the large quantity, and in the precise concentration when fluorine gas generated in the fluorine gas generation device is introduced into the semiconductor processing device.

### BRIEF DESCRIPTION OF THE DRAWINGS

[Fig.1] is a rough view of a fluorine gas supply system to which the present invention is applicable.
[Fig. 2] is a rough view of a comparative example of the fluorine gas supply system.

### Explanation of signs

1, 15 : fluorine gas supply source
2, 16 : inert gas supply source
3, 17: gas supply section
4, 6, 18, 20: gas piping
5, 19 : buffer tank
7, 21: semiconductor processing device
8: gas piping for circulating mixed gas
9: valve
10,11,22,23, aa: gas flow quantity adjustment device
12, 24 : pump
13: monitoring device
15: control circuit

### Description of the Embodiments

Hereinafter, one example of a preferred embodiment according to the present invention will be described with reference to the drawings.

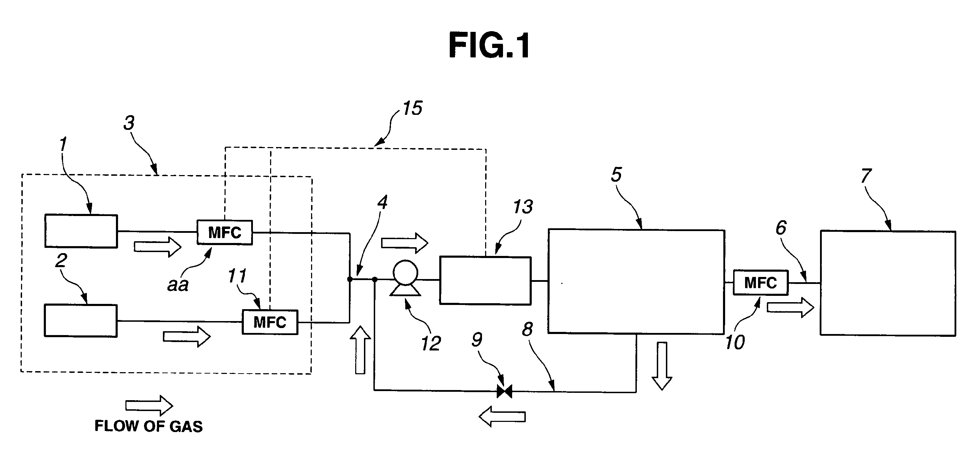

Fig. 1 shows a rough view of a fluorine gas supply system according to the present invention.

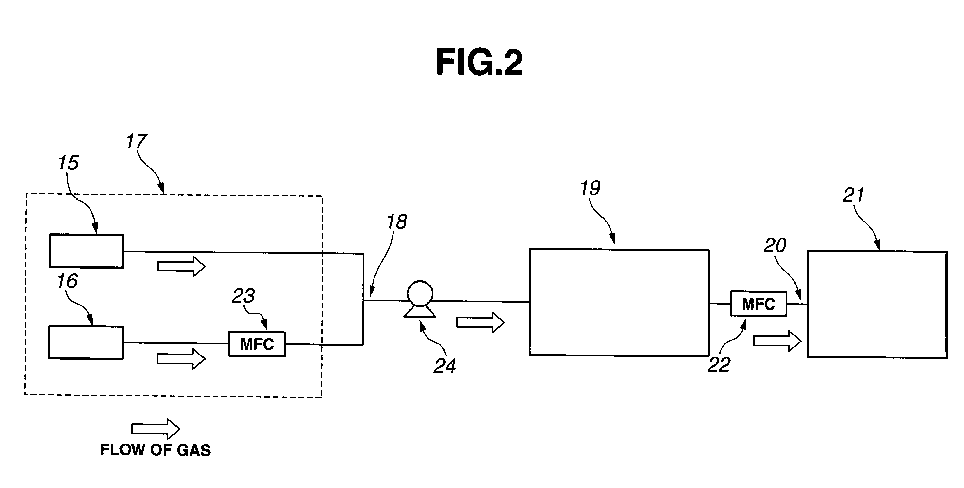

Fig. 2 shows a rough view of the fluorine gas supply system which is a comparative example with the present invention.
(Fluorine gas supply system according to the present invention)
First, the fluorine gas supply system according to the present invention shown in Fig. 1 will be described.

The fluorine gas supply system shown in Fig. 1 is a gas supply system which mixes fluorine gas obtained at a fluorine gas generation device with inert gas to adjust a fluorine gas concentration to a predetermined concentration and stores the mixed gas into a buffer tank, and supplies the mixed gas stored in the buffer tank to a semiconductor processing device which is a device to be an object of the gas supply and has the following feature. That is to say, the mixed gas stored into the buffer tank is introduced into a gas introducing piping before the adjustment of the mixed gas within the buffer tank to circulate the mixed gas so that the fluorine concentration in the mixed gas is uniformized.

The fluorine gas supply system shown in Fig. 1 includes a gas supply source 1 for supplying fluorine gas obtained in a fluorine gas generation device; and a gas supply source 2 for supplying inert gas to adjust a fluorine gas concentration to a predetermined concentration. Each gas supply source 1, 2 is connected to a buffer tank 5 in which each gas is mixed together and stored via a piping 4 in which each gas is introduced. A piping 6 is connected to buffer tank 5 so that the mixed gas stored in buffer tank 5 is supplied to semiconductor processing device 7.

In order to uniformize the concentration of fluorine gas of the mixed gas within buffer tank 5, a piping 8 to connect buffer tank 5 to piping 4 in which each gas is introduced is provided.

Furthermore, a bypass valve may be disposed in piping 8 to adjust the fluorine gas concentration within buffer tank 5 to modify the gas circulation flow quantity within the buffer tank.

The provision of this piping 8 to connect buffer tank 5 to piping 4 in which each gas is introduced causes the mixed gas once stored in buffer tank 5 to be introduced into piping 4 in which each gas is introduced so as to circulate the mixed gas. Thus, it becomes possible to adjust the mixed gas having a uniform fluorine concentration.

In addition, it is preferable to adjust the concentration of fluorine gas in the mixed gas within the buffer tank by performing an open-or-closure of a valve 9 and an opening angle adjustment of valve 9, the valve being disposed in piping 8 to connect buffer tank 5 to piping 4 into which each gas is introduced, with a necessity of circulating the mixed gas in the buffer tank according to conditions of the size of the buffer tank used and the fluorine gas concentration of the mixed gas and so forth taken into consideration.

It is preferable to dispose a pump 12 to circulate the mixed gas in a gas line into which the mixed gas is circulated, for example, in piping 8 to connect buffer tank 5 to piping 4 into which each gas is introduced, in order to circulate the mixed gas within buffer tank 5.

Furthermore, it is possible to control pump 12 installed in a gas line into which the mixed gas is circulated through an inverter and to perform a flow quantity control of the circulating gas according to the opening angle of valve 9 so that it becomes possible to arbitrarily control the fluorine gas concentration stored in buffer tank 5.

A gas flow quantity control device 11 which adjusts the flow quantity of gas supplied to buffer tank 5 is provided in the gas supply line of inert gas supply source 2.

A monitoring device 13 to control a concentration of fluorine gas in the mixed gas is disposed within gas introducing piping 4 connecting inert gas supply source 2 and buffer tank 5. Monitoring device 13 is connected to gas flow quantity adjustment device 11 disposed in inert gas supply source 2 to adjust the flow quantity of inert gas via a control circuit 15.

The flow quantity of fluorine gas obtained in the on-site fluorine gas generation device is generally adjusted according to a current value of an electrolyte bath mainly generating fluorine gas, a valve opening angle, and so forth. However, another gas flow quantity adjustment device aa which adjusts the flow quantity of fluorine gas may be disposed in a gas supply line of fluorine gas supply source 1.

In a case where gas flow quantity adjustment device aa is disposed which adjusts the flow quantity of fluorine gas in the gas supply line of fluorine gas supply source 1, monitoring device 13 can be connected to gas flow quantity adjustment device aa disposed in fluorine gas supply source 1 to adjust the flow quantity of fluorine gas via control circuit 15, in the same way as the case of inert gas supply source 1.

The site of monitoring device 13 is not specifically limited unless it is disposed at a location at which the mixed gas to be circulated can be analyzed. It is preferable to dispose monitoring device 13 in piping 8 to connect buffer tank 5 to piping 4 into which each gas is introduced or in a gas line immediately before gas is introduced into buffer tank 5.

Monitoring device 13 is used to measure the concentration of fluorine gas within the mixed gas. The obtained information of concentration is supplied via control circuit 15 and, on a basis of the supplied information, to adjust gas flow quantity adjustment device 11 which is disposed in the gas supply line of inert gas supply source 2 so that the concentration of fluorine within the mixed gas can be maintained at a predetermined concentration.

In addition, similarly, a still another gas flow quantity adjustment device may be disposed in the gas supply line of fluorine gas supply source 1 and monitoring device 13 is used to adjust the flow quantity of fluorine gas so that the fluorine gas concentration in the mixed gas can be adjusted.

Furthermore, it is preferable to dispose an in-line gas analyzer in monitoring device 13 to measure the concentration of fluorine gas. A special limitation is not placed on the in-line analyzer if the fluorine concentration is measurable as the in-line analyzer but it is particularly preferable to use an ultraviolet and visible spectrophotometer (UV-Vis) for the in-line analyzer.

A gas flow quantity adjustment device 10 is disposed in piping 6 to supply the mixed gas stored in buffer tank 5 to a semiconductor processing device 7. It is preferable to adjust the gas flow quantity according to a process requirement of semiconductor processing device used.

In order to maintain properly a mixed gas pressure in the buffer tank, it is preferable to dispose a gas pressure detection device to detect the gas pressure within the buffer tank. It is preferable to supply a value of the mixed gas pressure detected by the gas detection device to a rectifier (a fluorine gas introduction side) installed at the on-site fluorine gas generation device via the monitoring device and to perform a flow quantity control of fluorine gas according to a current value (a rise or a drop in the current value) of the rectifier.

A method of generating fluorine gas to be supplied includes a method for generating fluorine gas by electrolyzing hydrogen fluoride in an electrolysis bath constituted by a molten salt containing hydrogen fluoride and a method of generating fluorine gas according to a thermal decomposition reaction of a metallic fluoride solid body. However, the method described above is not specifically limited if fluorine gas is generated and supplied on site.

It should, herein, be noted that the term of on-site means that a mechanism for generating and supplying fluorine gas is combined with a predetermined processing device, for example, with a main processing unit of the semiconductor processing device.

Inert gas used herein includes argon, nitrogen, helium, neon, and so forth. Inert gas having no interaction with fluorine gas and no influence on the semiconductor processing device to be used may be adopted. A special limitation is not placed thereon.

As a material used for the buffer tank, metals such as nickel, monel, stainless steel, and so forth, each having a high durability against fluorine gas and each having a sufficient mechanical strength, can be listed. (Comparative example of fluorine gas supply system) Next, a comparative example shown in Fig. 2 to fluorine gas supply system according to the present invention shown in Fig. 1 will be described below. Hereinafter, in the same way as described with reference to Fig. 1, the comparative example of fluorine gas supply system shown in Fig. 2 will be described but basic structure and action are the same unless otherwise specified.

The fluorine gas supply system shown in Fig. 2 is a gas supply system for mixing fluorine gas obtained in fluorine gas generating device with inert gas to adjust fluorine gas to a predetermined concentration, for storing the mixed gas into the buffer tank, and for supplying the mixed gas to the semiconductor processing device which is an object device to which fluorine gas is to be supplied.

The fluorine gas supply system shown in Fig. 2 includes a gas supply section 17 having a gas supply source 15 for supplying fluorine gas obtained in the fluorine gas generation device and a gas supply source 16 for supplying inert gas to adjust fluorine gas to a predetermined concentration. Each gas supply section 15, 16 is connected to buffer tank 19 for mixing each gas and storing the mixed gas via a piping 18 into which each gas is introduced. A piping 20 is connected with buffer tank 19 so that the mixed gas stored in buffer tank 19 is supplied to a semiconductor processing device 21.

A gas flow quantity adjustment device 23 to adjust the flow quantity of inert gas supplied to buffer tank 19 is disposed in a gas supply line of each gas supply source 15, 16.

The gas flow quantity adjustment device is disposed in piping 20 to supply the mixed gas stored in buffer tank 19 to semiconductor processing device 21 so that, according to a process requirement of the semiconductor processing device to be used, the gas flow quantity is adjusted.

A pump 24 is disposed in a gas introducing piping 20 connecting between each gas supply source 15, 16 and buffer tank 19.
(Difference point between comparative example and the present invention)
Hereinafter, a difference point between the present invention and the comparative example of fluorine gas supply system will be described.

The comparative example of the fluorine gas supply system shown in Fig. 2 is different from the fluorine gas supply system according to the present invention shown in Fig. 1 in that the piping is not installed to circulate the mixed gas into the buffer tank which stores the mixed gas. Therefore, in the comparative example, in a case where the large-sized buffer tank is used, it is difficult to uniformize the mixed gas.

As countermeasures against them, the following methods have heretofore been taken. A: A method in which the mixed gas is left alone for a long time to uniformize the mixed gas. B: A method in which the mixed gas in the buffer tank is uniformized by using a large-sized fan. C: A method in which the gas previously diluted to a predetermined gas concentration using a gas mixing device (a static mixer) is introduced when gas is mixed.

However, these methods provide causes of making a modification of the fluorine gas concentration within the buffer tank difficult and of reducing productivity due to a wasteful consumption of time and due to an installation cost. In addition, it is possible to modify the fluorine gas concentration within the buffer tank by a combination of methods of B and C and install the monitoring device which measures the fluorine gas concentration. However, the number of equipments are increased so as to provide a cause of an increase in an installation cost.

On the other hand, the fluorine gas supply system according to the present invention shown in Fig. 1 has a feature such that the gas introducing piping to circulate the mixed gas into the buffer tank storing the mixed gas is disposed.

Therefore, the fluorine gas supply system according to the present invention has a feature such that the mixed gas within the buffer tank can be uniformized in a short time at a low cost and has a feature such that the mixed gas of a suitable fluorine gas concentration can be supplied for a process requirement (required fluorine gas concentration, fluorine use quantity, and so forth) of the semiconductor processing device to be used since it is possible to modify arbitrarily the concentration of fluorine gas within the buffer tank.

Furthermore, the fluorine gas supply system according to the present invention shown in Fig. 1 has a feature such that the monitoring device which measures the concentration of fluorine within the mixed gas is disposed so as to enable the adjustment of the flow quantity of inert gas in response to the obtained fluorine concentration and the fluorine generation quantity is adjusted according to the use quantity of fluorine in the semiconductor processing device so that fluorine gas having a precise concentration as compared with the comparative example of the fluorine gas supply system shown in Fig. 2 can be supplied. It should be noted that MFC in Figs. 1 and 2 is an abbreviation for a Mass Flow Controller.

## Claims

1. A system disposed within a gas supply system of a semiconductor processing device for supplying fluorine gas, comprising:
a gas supply section including gas supply sources of fluorine gas and inert gas;
a buffer tank storing a mixed gas of fluorine gas and inert gas;
a piping A into which gas of each of the gas supply sources is introduced and for connecting each of the gas supply sources to the buffer tank;
a piping B for connecting the buffer tank to the piping A and for circulating the mixed gas within the buffer tank to uniformize a concentration of fluorine within the mixed gas;
a gas piping C for connecting the buffer tank to the semiconductor processing device;
a gas flow quantity adjustment device disposed in the inert gas supply source of the gas supply section for adjusting a flow quantity of inert gas;
another gas flow quantity adjustment device disposed in the gas piping C for adjusting the flow quantity of gas to be supplied from the buffer tank to the semiconductor processing device; and
a monitoring device configured to measure the concentration of fluorine in the mixed gas and, in response to a measurement of the concentration of fluorine, to adjust the flow quantity adjustment device for adjusting the flow quantity of inert gas to maintain the concentration of fluorine at a predetermined concentration.

2. The system as claimed in claim 1, wherein the monitoring device comprises an in-line analyzer.

3. The system as claimed in claim 1, wherein the monitoring device comprises an ultraviolet and visible spectrophotometer (UV-Vis).
